# EUROPÄISCHE PATENTSCHRIFT

(11) **EP 1 138 085 B1**
(45) Veröffentlichungstag und Bekanntmachung des Hinweises auf die Patenterteilung: **14.01.2009**
(21) Anmeldenummer: 99963255.7
(22) Anmeldetag: 18.11.1999
(51) Int. Cl.: H01L 29/78, H01L 21/336

(54) **FELDEFFEKTGESTEUERTER TRANSISTOR UND VERFAHREN ZU DESSEN HERSTELLUNG**
FIELD EFFECT-CONTROLLED TRANSISTOR AND METHOD FOR PRODUCING THE SAME
TRANSISTOR A EFFET DE CHAMP ET SON PROCEDE DE PRODUCTION

(30) Priorität: 18.11.1998 DE 19853268
(43) Veröffentlichungstag der Anmeldung: 04.10.2001
(73) Patentinhaber: Qimonda AG, 81739 München (DE)
(72) Erfinder: WIDMANN, Dietrich, Verstorben (DE); WIEDER, Armin, D-82319 Starnberg (DE)
(74) Vertreter: Kottmann, Heinz Dieter
(86) Internationale Anmeldenummer: PCT/DE1999/003674
(87) Internationale Veröffentlichungsnummer: WO 2000/030181

(56) Entgegenhaltungen:
- EP-A- 0 510 667
- US-A- 4 979 014
- US-A- 5 563 082
- PATENT ABSTRACTS OF JAPAN vol. 1996, no. 09, 30. September 1996 (1996-09-30) & JP 08 139325 A (TOSHIBA CORP), 31. Mai 1996 (1996-05-31) & US 5 844 278 A 1. Dezember 1998 (1998-12-01)

## Beschreibung

Die Erfindung betrifft einen feldeffektgesteuerten Transistor, der auch bei Kanallängen von weniger als 50 nm funktionsfähig ist.

Planare MOS- und Junction-Transistoren stoßen bei etwa 50 nm Kanallänge an ihre Funktionsgrenzen. Für den Gatelängenbereich unterhalb 50 nm sind verschiedene Transistorstrukturen vorgeschlagen worden (siehe zum Beispiel H. Wong et al, IEDM 97, Seite 427 ff). Dabei wird vorgeschlagen, daß ein MOS-Transistor mit zwei Gateelektroden versehen ist, die auf einander gegenüberliegenden Seiten des Kanalbereichs angeordnet sind und so einen Stromfluß entlang zwei Oberflächen des Kanalbereichs steuern. Dabei sind sowohl vertikale Strukturen, bei denen ein Sourcegebiet, der Kanalbereich und ein Draingebiet in vertikaler Richtung in Bezug auf eine Hauptfläche einer Siliziumscheibe angeordnet sind und einen die Hauptfläche überragenden Stapel bilden, als auch planare Strukturen, in denen das Sourcegebiet, der Kanalbereich und das Draingebiet parallel zu der Hauptfläche der Siliziumscheibe angeordnet sind.

In H. Wong et al, IEDM 97, Seiten 427 ff, ist vorgeschlagen worden, einen planaren MOS-Transistor auf einem SOI-Substrat zu realisieren, bei dem eine Gateelektrode oberhalb und eine Gateelektrode unterhalb des Kanalbereichs angeordnet ist. Zur Herstellung des Transistors wird vorgeschlagen, auf ein Siliziumsubstrat eine dicke Siliziumoxidschicht, eine erste Siliziumnitridschicht, eine erste dünne Siliziumoxidschicht, eine Platzhalterschicht aus amorphem Silizium, eine zweite dünne Siliziumoxidschicht und eine zweite Siliziumnitridschicht aufzubringen und so zu strukturieren, daß die Oberfläche der dicken Siliziumoxidschicht in den Bereichen für Source und Drain freigelegt wird. In einem der Source-/Draingebiete wird darüber hinaus ein Fenster in der dicken Siliziumoxidschicht bis auf die Oberfläche des Siliziumsubstrats geöffnet. Die Platzhalterschicht aus amorphem Silizium wird im Bereich des Gatestapels entfernt. Nachfolgend wird durch selektive Epitaxie ausgehend von der freiliegenden Oberfläche des Siliziumsubstrats monokristallines Silizium im Bereich der Source-/Draingebiete und des Kanalbereichs aufgewachsen. Durch Entfernen der strukturierten ersten Siliziumnitridschicht und zweiten Siliziumnitridschicht und Abscheiden von dotiertem Polysilizium werden die beiden Gateelektroden oberhalb und unterhalb des Kanalbereichs, der bei der selektiven Epitaxie gewachsen ist, gebildet. Dieses Verfahren ist mit Standardschritten der Halbleiterprozeßtechnologie nicht kompatibel.

In D. Hisamoto et al, IEDM 89, Seite 833 bis 836, ist ein planarer MOS-Transistor vorgeschlagen worden, der ein Sourcegebiet, ein Kanalgebiet und ein Draingebiet in einem Siliziumsteg aufweist, der durch einen Feldoxidbereich gegenüber einem darunter angeordneten Siliziumsubstrat isoliert ist. Eine Gateelektrode überlappt den Siliziumsteg im Bereich des Kanalgebietes und steuert so entlang beider Flanken des Siliziumsteges einen Kanalstrom. Die Stromrichtung verläuft parallel zur Hauptfläche des Siliziumsubstrats. Zur Herstellung dieses Transistors wird vorgeschlagen, an der Oberfläche eines Siliziumsubstrats den Siliziumsteg zu strukturieren, der mit einer Siliziumnitridschicht bedeckt ist und dessen Flanken mit Siliziumnitridspacern versehen werden. Anschließend wird die Oberfläche des Siliziumsubstrats unter die Siliziumnitridspacer unterätzt. Der Feldoxidbereich wird durch lokale Oxidation der Oberfläche des Siliziumsubstrats gebildet. Die Oxidation wird dabei solange fortgesetzt, bis beiderseits des Stegs entstehende Feldoxidbereiche durch die sich bildenden Vogelschnäbel unterhalb des Steges zusammentreffen. Auch dieser Herstellprozeß ist mit Standardschritten der Halbleiterprozeßtechnik nicht kompatibel.

Weiterhin ist aus PATENT ABSTRACTS OF JAPAN, vol. 1996, no. 9, 30. Sept. 1996 & JP 08 139325 A, 31. Mai 1996 & US 5,844,278 A eine Halbleitervorrichtung bekannt, bei der eine Gateelektrode über einen Isolierfilm auf eine Hauptfläche eines Halbleiterkörpers sowie auf Wände von zwei Gräben aufgetragen ist. Die Gräben selbst sind teilweise mit Leitermaterial gefüllt, während ein aktives Gebiet im Halbleiterkörper im Bereich zwischen dem leitenden Material liegt.

Die US-A-4,979,014 beschreibt einen MOS-Transistor, bei dem in ein Siliziumsubstrat parallel zueinander verlaufende Gräben geätzt sind, deren Wände mit einem Siliziumoxidfilm belegt sind. Die Gräben sind nacheinander mit einem polykristallinen Siliziumfilm, einem Siliziumdioxidfilm, einem weiteren polykristallinen Siliziumfilm und einem weiteren Siliziumdioxidfilm gefüllt.

Die EP-A-0 510 667 zeigt eine Halbleitervorrichtung mit einem Transistor mit isoliertem Gate, bei dem Source bzw. Drain in eine Ausnehmung eines Substrates eingebracht und dort über eine Isolierschicht von einer Gateelektrode umgeben sind.

Schließlich ist aus US-A-5,563,082 ein Verfahren zum Herstellen eines MOS-Transistors bekannt, bei dem Source bzw. Drain an entgegengesetzten Enden einer rechteckförmigen Ausnehmung eines Substrates liegen und Gate entlang den beiden anderen Seiten dieses Rechteckes angebracht ist.

Der Erfindung liegt das Problem zugrunde, einen feldeffektgesteuerten Transistor anzugeben, der bei Gatelängen unterhalb von 50 nm funktionsfähig ist und der mit Standardschritten der Halbleiterprozesstechnik herstellbar ist. Ferner soll ein Verfahren zur Herstellung eines derartigen Transistors angegeben werden.

Dieses Problem wird gelöst durch einen feldeffektgesteuerten Transistor gemäss Anspruch 1 sowie ein Verfahren zu dessen Herstellung gemäss Anspruch 5. Weitere Ausgestaltungen der Erfindung gehen aus den übrigen Ansprüchen hervor.

Der feldeffektgesteuerte Transistor ist in einem Halbleitersubstrat realisiert. In dem Halbleitersubstrat ist ein aktives Gebiet vorgesehen, das ein Sourcegebiet, ein Kanalgebiet und ein Draingebiet aufweist, die jeweils an einer Hauptfläche des Halbleitersubstrats angrenzen, so dass ein Strom zwischen Sourcegebiet und Draingebiet parallel zur Hauptfläche des Halbleitersubstrats fliesst. In der Hauptfläche des Halbleitersubstrats ist mindestens ein Graben vorgesehen, der an das Kanalgebiet angrenzt und in dem ein Teil einer Gate- elektrode angeordnet ist. In dem Transistor reicht ein Teil der Gateelektrode in die Tiefe des Halbleitersubstrats hinein, so dass über die Gateelektrode ein Strom gesteuert werden kann, der parallel zur Hauptfläche des Substrats in einer Flanke des Kanalgebiets fliesst, die die Hauptfläche des Substrats schneidet. Die effektive Kanalweite ist somit unabhängig von der Breite des Kanalgebiets an der Hauptfläche des Halbleitersubstrats.

Der Transistor kann sowohl als MOS-Transistor als auch als Junction-Transistor realisiert werden. Im Fall eines MOS- Transistors wird die Oberfläche des Kanalgebietes mindestens im Bereich des Grabens mit einem Gatedielektrikum versehen.

Im Hinblick auf die Integration in die Standard-Silizium- Prozess-technik ist es vorteilhaft, ein Halbleitersubstrat zu verwenden, das mindestens im Bereich der Hauptfläche monokristallines Silizium aufweist. Als Halbleitersubstrat sind insbesondere eine monokristalline Siliziumscheibe, die monokristalline Siliziumschicht eines SOI-Substrats, ein SiGe-Substrat oder ein SiC-Substrat geeignet.

Vorzugsweise sind auf einander gegenüberliegenden Flanken des Kanalgebiets jeweils Teile der Gateelektrode angeordnet, so daß der Transistor effektiv zwei einander gegenüberliegende Gateelektrodenteile aufweist. Diese Teile sind jeweils in einem ersten Graben und einem zweiten Graben angeordnet. Durch Vorsehen zweier Gateelektrodenteile werden an den einander gegenüberliegenden Flanken des Kanalbereichs Inversionskanäle gesteuert. Dadurch wird der Durchgriff der Drainspannung auf das Kanalgebiet reduziert, so daß der aus der Literatur bekannte begrenzende "Drain Induced Barrier Lowering" praktisch unwirksam ist. Ferner wird durch das Vorsehen zweier Gateelektrodenteile der störende Einfluß der Substratspannung auf den Kanalbereich reduziert.

Vorzugsweise ist die Ausdehnung des Sourcegebietes und des Draingebietes senkrecht zur Hauptfläche des Halbleitersubstrats kleiner oder gleich der Tiefe des Grabens bzw. der Tiefe der Gräben. Dadurch wird die Fläche, über die sich ein leitender Inversionskanal bildet, vergrößert, so daß die Stromergiebigkeit gegenüber planaren Anordnungen vervielfacht wird. Außerdem wird dadurch die Transistorsteilheit vervielfacht, die für die Ansteuerung des Transistors wesentlich ist.

Vorzugsweise ist die Abmessung der Gateelektrode parallel zur Hauptfläche auf die Abmessung des Kanalgebiets beschränkt, so daß die Drain-Gate-Überlappkapazität minimiert wird. Dadurch werden parasitäre Kapazitäten minimiert und eine erhöhte Transistorsteilheit erzielt, was für schnelles Schaltverhalten und ein gutes Hochfrequenzverhalten in den GHz-Bereich hinein von Vorteil ist.

Zur Isolation des Transistors innerhalb einer integrierten Schaltung ist es vorteilhaft, eine Isolationsstruktur vorzusehen, die das aktive Gebiet und den Graben bzw. die Gräben umgibt.

Zur Herstellung des Transistors wird in der Hauptfläche des Halbleitersubstrats ein Graben erzeugt, der das aktive Gebiet seitlich definiert. Nachfolgend wird eine Gateelektrode gebildet, die teilweise in dem Graben angeordnet ist.

Zur Herstellung des Transistors als MOS-Transistor wird an der Oberfläche des Kanalgebietes ein Gatedielektrikum erzeugt.

Zur selbstjustierenden Bildung der Gateelektrode wird eine erste leitfähige Schicht abgeschieden, aus der durch anisotropes Ätzen leitfähige Spacer an den Flanken des aktiven Gebietes gebildet werden. Anschließend wird eine Isolationsstruktur erzeugt, die das aktive Gebiet und die leitfähigen Spacer umgibt. Die Oberfläche der leitfähigen Spacer parallel zur Hauptfläche des Halbleitersubstrats wird dabei freigelegt. Es wird eine zweite leitfähige Schicht abgeschieden, die über die freiliegende Oberfläche der leitfähigen Spacer mit diesen in Verbindung steht. Die Gateelektrode wird durch Strukturierung der zweiten leitfähigen Schicht und der leitfähigen Spacer gebildet. Als Material für die leitfähigen Schichten ist insbesondere dotiertes polykristallines oder amorphes Silizium, Metallsilizid und/oder Metall geeignet. Die Strukturierung zur Fertigstellung der Gateelektrode erfolgt vorzugsweise durch maskiertes Ätzen. Die dabei verwendete Maske legt die Gatelänge fest. Durch Einsatz eines Feinstrukturierungsschrittes, zum Beispiel einer Elektronenstrahllithographie, einem Imprint-Verfahren oder durch Anwendung einer Spacertechnik können dabei Gatelängen unter 50 nm, insbesondere 10 bis 50 nm, erzielt werden.

Die Herstellung der Source-/Draingebiete erfolgt vorzugsweise selbstjustiert zur Gatelektrode durch Implantation.

Vorzugsweise weist der Graben einen Querschnitt auf, der dem Querschnitt der Isolationsstruktur und der Gateelektrode entspricht. Die Isolationsstruktur wird in diesem Fall zum Beispiel durch Abscheidung einer isolierenden Schicht, die den Graben vollständig auffüllt, und chemisch mechanisches Polieren gebildet.

Im folgenden wird die Erfindung anhand eines Ausführungsbeispieles, das in den Figuren dargestellt ist, näher erläutert.
- Figur 1: zeigt einen Schnitt durch ein Halbleitersubstrat, nach Erzeugung einer ersten Siliziumoxidschicht und einer zweiten Siliziumoxidschicht und einer Maske, die ein aktives Gebiet definiert.
- Figur 2: zeigt eine Aufsicht auf Figur 1.
- Figur 3: zeigt einen Schnitt durch das Halbleitersubstrat nach der Strukturierung des aktiven Gebietes in dem Halb- leitersubstrat, nach Bildung eines Gatedielektrikums und nach der Erzeugung von leitfähigen Spacern an den Flanken des aktiven Gebietes.
- Figur 4: zeigt den Schnitt durch das Halbleitersubstrat nach einer weiteren Atzung in das Halbleitersubstrat.
- Figur 5: zeigt eine Aufsicht auf das Halbleitersubstrat nach der Bildung einer Isolationsstruktur, der Bildung ei- ner Gateelektrode und Auffüllen von Zwischenräumen zwischen dem Sourcegebiet und dem Draingebiet und der Isolationsstruktur mit isolierendem Material.
- Figur 6: zeigt den in Figur 5 mit VI-VI bezeichneten Schnitt.
- Figur 7: zeigt den in Figur 5 mit VII-VII bezeichneten Schnitt.
- Figur 8: zeigt den in Figur 5 mit VIII-VIII bezeichneten Schnitt.

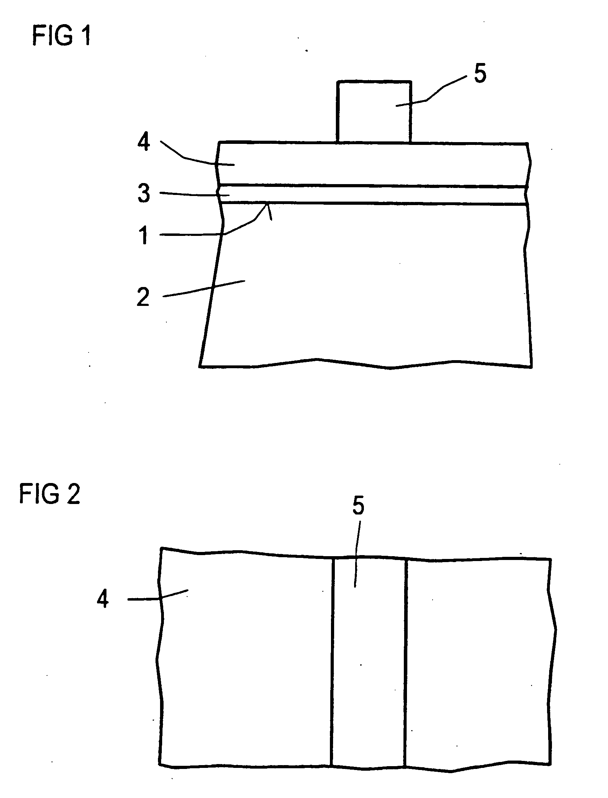

Auf einer Hauptfläche 1 eines Halbleitersubstrats 2 aus p-dotiertem monokristallinem Silizium mit einer Dotierstoffkonzentration von 10¹⁵ cm⁻³ wird durch thermische Oxidation eine erste Siliziumoxidschicht 3 aufgebracht. Die erste Siliziumoxidschicht 3 weist eine Dicke von 5 nm auf. Auf die erste Siliziumoxidschicht 3 wird eine erste Siliziumnitridschicht 4 abgeschieden, die eine Dicke von 20 nm aufweist. Auf der Oberfläche der ersten Siliziumnitridschicht wird eine Maske 5 erzeugt, die ein von einem Graben umgebenes aktives Gebiet definiert (siehe Figur 1 und Figur 2). Die Maske 5 weist einen im wesentlichen rechteckigen Querschnitt parallel zur Hauptfläche 1 auf, der Abmessungen von 40 nm x 500 nm aufweist.

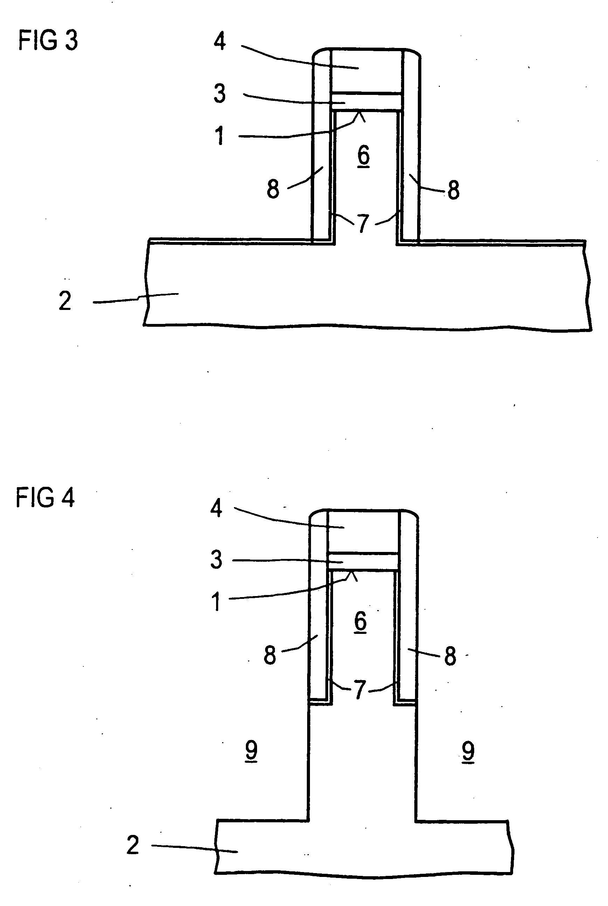

Durch anisotropes Ätzen werden die erste Siliziumnitridschicht 4, die erste Siliziumoxidschicht 3 und das Halbleitersubstrat 2 geätzt, wobei in dem Halbleitersubstrat 2 ein von einem Graben umgebenes aktives Gebiet gebildet wird (siehe Figur 3). Als Ätzgase werden CF₄ und H₂ verwendet. Die Ätzung erfolgt bis in eine Tiefe von 500 nm unterhalb der Hauptfläche 1.

Durch thermische Oxidation wird an den Flanken des aktiven Gebietes 6 ein Gatedielektrikum 7 aus SiO₂ in einer Schichtdicke von 3 nm gebildet.

Durch Abscheiden einer ersten leitfähigen Schicht aus dotiertem Polysilizium und Rückätzen der ersten leitfähigen Schicht werden an den Flanken des aktiven Gebietes 6 leitfähige Spacer 8 aus dotiertem Polysilizium gebildet (siehe Figur 3). Die leitfähigen Spacer 8 umgeben das aktive Gebiet 6 ringförmig.

In einem weiteren anisotropen Ätzprozeß unter Verwendung von SiF₄ und H₂ werden freiliegende Teile des Gatedielektrikums 7 entfernt. Nachfolgend wird durch anisotropes Ätzen mit CF₄ in das Halbleitersubstrat 2 geätzt, so daß seitlich des aktiven Gebietes 6 und der leitfähigen Spacer 8 ein Isolationsgraben 9 entsteht, der bezogen auf die Hauptfläche 1 eine Tiefe von 1 µm aufweist (siehe Figur 4).

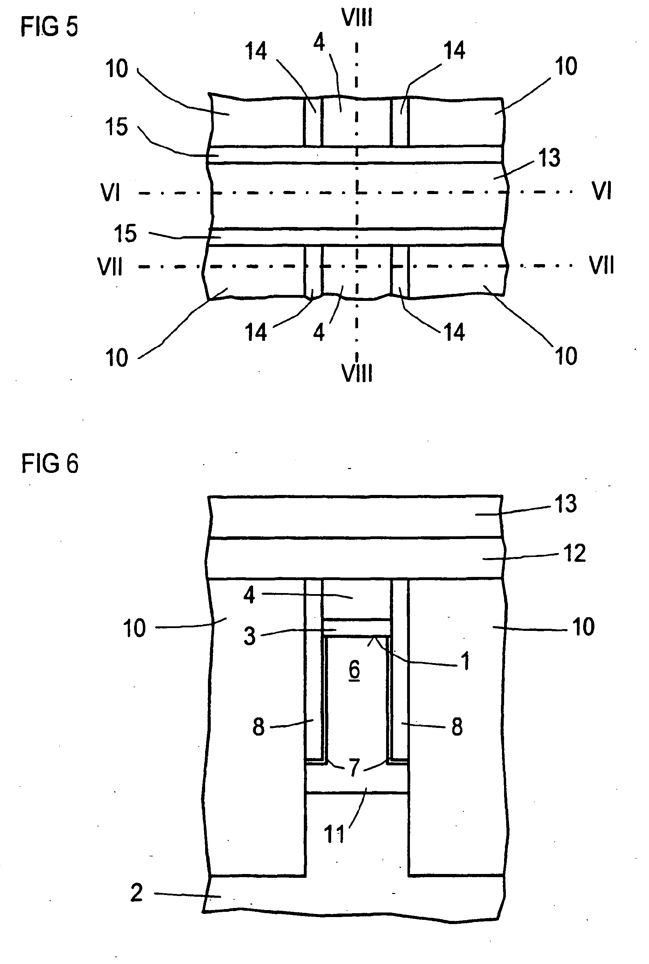

Die Isolationsgräben werden durch Abscheidung einer zweiten SiO₂-Schicht aufgefüllt. Durch anschließendes chemisch mechanisches Polieren, bei dem die erste Siliziumnitridschicht 4 als Ätzstop wirkt, wird aus der zweiten Siliziumoxidschicht eine Isolationsstruktur 10 gebildet, die die Isolationsgräben 9 auffüllt (siehe Figur 6).

Durch Implantation mit Bor wird in dem aktiven Gebiet 6 eine Kanaldotierung 11 mit einer Dotierstoffkonzentration von 5 x 10¹⁷ cm⁻³ erzeugt.

Es wird ganzflächig eine zweite leitfähige Schicht 12 und eine zweite Siliziumnitridschicht 13 abgeschieden und mit Hilfe einer Maske (nicht dargestellt) strukturiert. Die strukturierte zweite leitfähige Schicht 12 und die strukturierte zweite Si₃N₄-Schicht 13 weisen einen streifenförmigen Querschnitt auf, der quer zu der Längsausdehnung des aktiven Gebietes 6 verläuft und der parallel zur Längsausdehnung des aktiven Gebietes 6 eine Breite von 40 nm aufweist. Bei der Strukturierung der zweiten leitfähigen Schicht 12 werden die freiliegenden Bereiche der leitfähigen Spacer 8 ebenfalls entfernt. Die Strukturierung erfolgt durch anisotropes Ätzen mit SiF₄ und H₂.

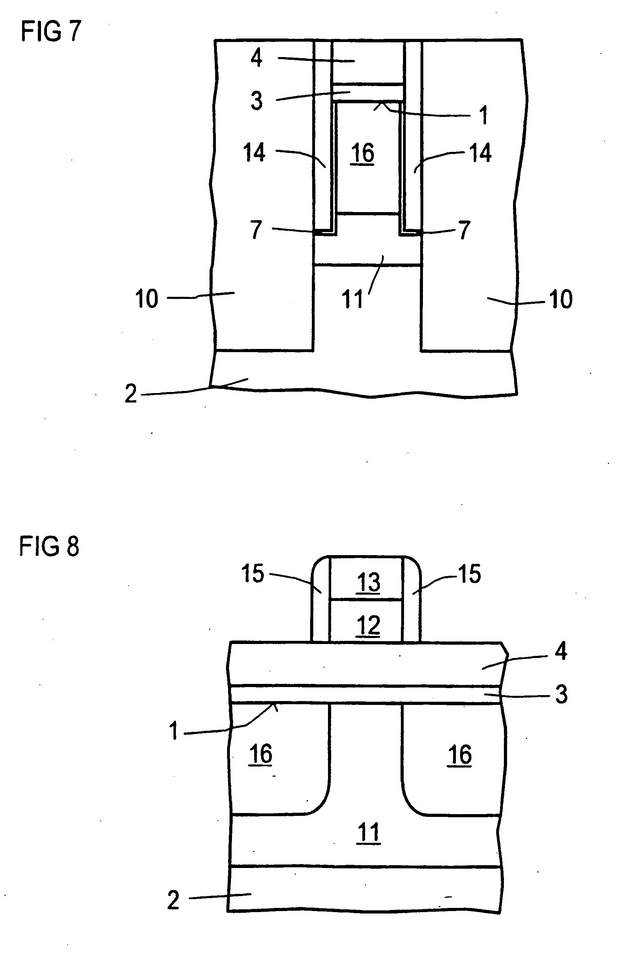

Durch Abscheiden einer dritten Siliziumoxidschicht und Rückätzen der dritten Siliziumoxidschicht werden Zwischenräume zwischen dem aktiven Gebiet 6 und der Isolationsstruktur 10, die außerhalb der strukturierten zweiten leitfähigen Schicht 12 beim Entfernen der leitfähigen Spacer 8 entstehen, mit einer isolierenden Füllung 14 versehen (siehe Figur 7).

Die Flanken der strukturierten zweiten leitfähigen Schicht 12 und der strukturierten zweiten Siliziumnitridschicht 13 werden durch Abscheidung einer dritten Siliziumnitridschicht und anisotropes Rückätzen der dritten Siliziumnitridschicht mit Siliziumnitridspacern 15 versehen (siehe Figur 5 und Figur 8). Durch Implantation mit As mit einer Energie von 50 keV und einer Dosis von 2 x 10¹⁵ cm⁻² werden selbstjustiert zu der strukturierten zweiten leitfähigen Schicht 12 Source-/Draingebiete 16 erzeugt (siehe Figur 7 und Figur 8). Die Tiefe der Source-/Draingebiete 16 unterhalb der Hauptfläche 1 ist dabei geringer als die Tiefe, bis in die sich die leitfähigen Spacer 8 erstrecken.

Die leitfähigen Spacer 8 sind über die strukturierte zweite leitfähige Schicht 12 miteinander verbunden. Die leitfähigen Spacer 8 und der sie verbindende Teil der zweiten strukturierten leitfähigen Schicht 12 wirken als Gateelektrode. Da sich die leitfähigen Spacer 8 tiefer in das Halbleitersubstrat 1 hinein erstrecken als die Source-/Draingebiete 16, bildet sich bei entsprechender Ansteuerung der Gateelektrode über die gesamte Tiefe der Source-/Draingebiete 16 zwischen den Source-/Draingebieten 16 ein leitender Inversionskanal. Der Bereich des aktiven Gebietes 6 zwischen den Source-/Draingebieten 16 wirkt somit über die gesamte Tiefe als Kanalbereich.

Zur Fertigstellung des Transistors wird eine Mehrlagenmetallisierung nach bekannten Verfahren (nicht dargestellt) erzeugt.

Das Ausführungsbeispiel behandelt einen n-Kanal-Transistor, die Erfindung ist ebenso als p-Kanal-Transistor ausführbar. Darüber hinaus können die leitfähigen Schichten aus anderem leitfähigem Material, insbesondere einem Metallsilizid oder Metall, gebildet werden. Ferner kann sich das Gatedielektrikum 7 auch im Bereich der Hauptfläche 1 des aktiven Gebietes befinden, so daß sich auch entlang der Hauptfläche ein leitender Inversionskanal ausbilden kann. In diesem Fall entfallen die erste Siliziumoxidschicht und die erste Siliziumnitridschicht zwischen dem aktiven Gebiet 6 und der zweiten leitfähigen Schicht 12. Falls technologisch erforderlich, können die Source-/Draingebiete 16 mit einem LDD-Profil gebildet werden.

## Patentansprüche

1. Feldeffektgesteuerter Transistor,
- bei dem in einem Halbleitersubstrat (2) ein aktives Gebiet (6) vorgesehen ist, das ein Sourcegebiet, ein Draingebiet und ein Kanalgebiet aufweist, die jeweils an eine Hauptfläche (1) des Halbleitersubstrats (2) angrenzen, und
- bei dem in der Hauptfläche (1) ein erster Graben und ein zweiter Graben vorgesehen sind, die an einander gegenüberliegende Flanken des aktiven Gebiets (6) angrenzen und in denen jeweils Teile (8) der Gateelektrode angeordnet sind,
- bei dem die Gateelektrode aus zwei an gegenüberliegenden Seiten des aktiven Gebiets (6) vorgesehenen leitfähigen Spacern (8), die sich im Bereich des Kanalgebietes und innerhalb einer strukturierten leitfähigen Schicht (12) befinden, und einem diese leitfähigen Spacer (8) verbindenden Teil der leitfähigen Schicht (12) besteht,
- bei dem der erste und der zweite Graben durch eine Isolationsstruktur (10) aufgefüllt sind, so dass die leitfähigen Spacer (8) zwischen dem aktiven Gebiet (6) und der Isolationsstruktur liegen, wobei sich die leitfähige Schicht (12) über die aufgefüllten Größen hinweg erstreckt, und
- bei dem auf zwei anderen einander gegenüberliegenden Seiten des aktiven Gebiets (6) zwischen diesem und der Isolationsstruktur (10) gebildete Zwischenräume mit isolierenden Füllungen (14), die sich im Bereich des Sourcegebietes und des Draingebietes und außerhalb der strukturierten leitfähigen Schicht (12) befinden, versehen sind.

2. Feldeffektgesteuerter Transistor nach Anspruch 1,
**Dadurch gekennzeichnet, dass**
die Oberfläche des aktiven Gebiets (6) mindestens im Bereich des ersten und zweiten Grabens mit einem Gatedielektrikum (7) versehen ist.

3. Feldeffektgesteuerter Transistor nach Anspruch 1 oder 2,
**dadurch gekennzeichnet, dass**
die Ausdehnung des Sourcegebietes (16) und des Draingebietes (16) senkrecht zur Hauptfläche (1) kleiner oder gleich der Tiefe des ersten bzw. zweiten Grabens ist.

4. Feldeffektgesteuerter Transistor nach einem der Ansprüche 1 bis 3,
**dadurch gekennzeichnet, dass**
die Isolationsstruktur (10) das aktive Gebiet (6) und den Graben umgibt.

5. Verfahren zur Herstellung eines feldeffektgesteuerten Transistors nach einem der Ansprüche 1 bis 4, bei dem:
- in einer Hauptfläche (1) eines Halbleitersubstrats (2) ein erster und ein zweiter Graben erzeugt werden, die ein aktives Gebiet (6) seitlich definieren, das ein Sourcegebiet (16), ein Kanalgebiet und ein Draingebiet (16) aufweist, die jeweils an die Hauptfläche (1) des Halbleitersubstrates (2) angrenzen,
zur Bildung einer Gateelektrode die teilweise in dem Graben angeordnet ist eine weitere leitfähige Schicht abgeschieden wird, aus der durch anisotropes Ätzen leitfähige Spacer (8) auf zwei einander gegenüberliegenden Seiten des aktiven Gebietes (6) gebildet werden,
- eine Isolationsstruktur (10) erzeugt wird, die das aktive Gebiet (6) und die leitfähigen Spacer (8) umgibt,
- eine leitfähige Schicht (12) abgeschieden wird, die mit den leitfähigen Spacern (8) in Verbindung steht,
- die Gateelektrode (8, 12) durch Strukturierung der leitfähigen Schicht (12) und der leitfähigen Spacer (8) gebildet wird, und
- bei der Strukturierung der leitfähigen Spacer (8) im Bereich des Sourcegebietes (16) und des Draingebietes (16) zwischen der Isolationsstruktur (10) und dem aktiven Gebiet (6) ein Zwischenraum entsteht, der mit isolierendem Material (14) aufgefüllt wird.

6. Verfahren nach Anspruch 5,
**dadurch gekennzeichnet , dass**
das Sourcegebiet (16) und das Draingebiet (16) durch Implantation selbstjustiert zu der leitfähigen Schicht (12) und der Isolationsstruktur (10) gebildet werden.

## Claims

1. Field-effect-controlled transistor,
- in which there is provided in a semiconductor substrate (2) an active region (6) having a source region, a drain region and a channel region, which each adjoin a main area (1) of the semiconductor substrate (2), and
- in which a first trench and a second trench are provided in the main area (1), which trenches adjoin mutually opposite sidewalls of the active region (6) and in each of which trenches parts (8) of the gate electrode are arranged,
- in which the gate electrode comprises two conductive spacers (8) which are provided on opposite sides of the active region (6) and are situated in the region of the channel region and inside a patterned conductive layer (8, 12), and a part of the conductive layer (12) which connects said conductive spacers (8),
- in which the first and the second trench are filled by an insulation structure (10), so that the conductive spacers (8) lie between the active region (6) and the insulation structure, the conductive layer (12) extending across the filled trenches, and
- in which on two other mutually opposite sides of the active region (6), interspaces formed between the latter and the insulation structure (10) are provided with insulating fillings
(14), which are situated in the region of the source region and of the drain region and outside the patterned conductive layer (8, 12).

2. Field-effect-controlled transistor according to Claim 1,
**characterized in that**
the surface of the active region (6) is provided with a gate dielectric (7) at least in the region of the first and second trenches.

3. Field-effect-controlled transistor according to Claim 1 or 2,
**characterized in that**
the extent of the source region (16) and of the drain region (16) perpendicularly to the main area (1) is less than or equal to the depth of the first and/or second trench.

4. Field-effect-controlled transistor according to one of Claims 1 to 3,
**characterized in that**
the insulation structure (10) surrounds the active region (6) and the trench.

5. Method for fabricating a field-effect-controlled transistor according to one of claims 1 to 4, in which:
- a first and a second trench are produced in a main area (1) of a semiconductor substrate (2), which trenches laterally define an active region (6) having a source region (16), a channel region and a drain region (16), which each adjoin the main area (1) of the semiconductor substrate (2),
- in order to form a gate electrode, which is partially arranged in the trench, a further conductive layer is deposited, from which layer, by means of anisotropic etching, conductive spacers (8) are formed on two mutually opposite sides of the active region (6),
- an insulation structure (10) is produced, which surrounds the active region (6) and the conductive spacers (8),
- a conductive layer (12) is deposited, which is connected to the conductive spacers (8),
- the gate electrode (8, 12) is formed by patterning the conductive layer (12) and the conductive spacers (8), and
- an interspace is produced during the patterning of the conductive spacers (8) in the region of the source region (16) and of the drain region (16) between the insulation structure (10) and the active region (6), said interspace being filled with insulating material (14).

6. Method according to Claim 5,
**characterized in that**
the source region (16) and the drain region (16) are formed by means of implantation in a self-aligned manner with respect to the second conductive layer (12) and the insulation structure (10).

## Revendications

1. Transistor commandé par effet de champ,
- dans lequel il est prévu dans un substrat (2) semi-conducteur, une zone (6) active qui a une zone de source, une zone de drain, une zone de canal, qui sont respectivement voisines d'une surface (1) principale du substrat (2) semi-conducteur, et
- dans lequel il est prévu dans la surface (1) principale un premier sillon et un deuxième sillons qui sont voisins de flancs mutuellement opposés de la zone (6) active et dans lesquels sont disposées respectivement des parties (8) de l'électrode de grille,
- dans lequel l'électrode de grille est constituée de deux espaceurs (8) conducteurs, qui sont prévus sur des côtés opposés de la zone (6) active et qui se trouvent dans la région de la zone de canal et au sein d'une couche (12) conductrice structurée, et d'une partie de la couche (12) conductrice reliant ces espaceurs (8) conducteurs,
- dans lequel le premier et le deuxième sillons sont remplis d'une structure (10) isolante de sorte que les espaceurs (8) conducteurs se trouvent entre la zone (6) active et la structure isolante, la couche (12) conductrice s'étendant au-delà de ce qui est rempli et,
- dans lequel il est prévu sur deux autres côtés mutuellement opposés de la zone (6) active des espaces intermédiaires formés entre celle-ci et la structure (10) isolante et ayant des garnissages (14) isolants qui se trouvent dans la région de la zone de source et de la zone de drain et à l'extérieur de la couche (12) conductrice structurée.

2. Transistor commandé par effet de champ suivant la revendication 1,
**caractérisé en ce que**
la surface de la zone (6) active est munie d'un diélectrique (7) de grille au moins dans la zone du premier et du deuxième sillons.

3. Transistor commandé par effet de champ suivant la revendication 1 ou 2,
**caractérisé en ce que**
l'étendue de la zone (16) de source et de la zone (16) de drain perpendiculairement à la surface (1) principale est inférieure ou égale à la profondeur du premier ou du deuxième sillon.

4. Transistor commandé par effet de champ suivant l'une des revendications 1 à 3,
**caractérisé en ce que**
la structure (10) isolante entoure la zone (6) active et le sillon.

5. Procédé de fabrication d'un transistor commandé par effet de champ suivant l'une des revendications 1 à 4, dans lequel :
- on produit dans une première surface (1) principale d'un substrat (2) semi-conducteur un premier et un deuxième sillons qui définissent latéralement une zone (6) active qui a une zone (16) de source, une zone de canal et une zone (16) de drain, qui sont respectivement voisines de la surface (1) principale du substrat (2) semi-conducteur,
- pour la formation d'une électrode de grille qui est disposée en partie dans le sillon, on dépose une autre couche conductrice à partir de laquelle on forme par attaque anisotrope des espaceurs (8) conducteurs sur deux côtés mutuellement opposés de la zone (6) active,
- on produit une structure (10) isolante qui entoure la zone (6) active et les espaceurs (8) conducteurs,
- on dépose une couche (12) conductrice qui est en liaison avec les espaceurs (8) conducteurs,
- on forme l'électrode (8,12) de grille en structurant la couche (12) conductrice et les espaceurs (8) conducteurs, et
- lors de la structuration des espaceurs (8) conducteurs, on crée dans la région de la zone (16) de source et de la zone (16) de drain entre la structure (10) isolante et la zone (6) active un espace intermédiaire que l'on remplit de matière (14) isolante.

6. Procédé suivant la revendication 5,
**caractérisé en ce que**
on forme la zone (16) de source et la zone (16) de drain par implantation avec auto-alignement par rapport à la couche (12) conductrice et la structure (10) isolante.
